# EUROPEAN PATENT APPLICATION

(11) **EP 0 672 913 A2**
(43) Date of publication of application: **20.09.1995**
(21) Application number: 95301609.4
(22) Date of filing: 09.03.1995
(51) Int. Cl.: G01R 33/032

(54) **Magnetic field sensor**

(30) Priority: 17.03.1994 GB 9405265
(71) Applicant: LUCAS INDUSTRIES PUBLIC LIMITED COMPANY, Solihull, West Midlands B91 3TX (GB)
(72) Inventor: Logan, John Robert, Danville, California 94526 (US)
(74) Representative: Robinson, John Stuart

(57) **Abstract**

A magnetic field sensor comprises a monocrystalline silicon body (1) etched to form a well (5) with a reflector (6) and a silicon beam (8). A magnetostrictive layer (10), for instance of nickel, is formed on the beam (8), whose resonant frequency is therefore a function of magnetic field. Light supplied via an optical fibre (4) and the reflector (6) causes the beam (8) to oscillate and its resonant frequency is determined from light passing back via the reflector (6) and the fibre (4).

## Description

The present invention relates to a magnetic field sensor.

Magnetostriction, whereby the dimensions of a material change with changes in magnetic field strength, can be utilised to form a magnetic field sensor. DE-A-4 028 366 describes a sensor in which a foil of magnetostrictive material forms one electrode of a capacitor. Changes in the dimensions of the magnetostrictive foil with changing magnetic field alters the separation between the plates of the capacitor, thereby causing the capacitance to vary with magnetic field.

Further magnetic effects are known. A "Delta E" effect is observed in certain magnetic materials, such as amorphous iron alloys, in which the elastic modulus of the material is a function of magnetic field.

According to the present invention, there is provided a magnetic field sensor comprising a beam and changing means responsive to a magnetic field for changing a measurable property of the beam.

Preferably the measurable property of the beam is the resonant frequency of the beam.

Preferably the beam is made of silicon. Advantageously the silicon is monocrystalline silicon. Alternatively the beam may be made of a metal exhibiting magnetostriction, such as nickel, or a combination of a magnetostrictive metal and silicon, or of a magnetostrictive coating on any suitable support material. Another example of a magnetostrictive metal suitable for the sensor is an iron, cobalt, silver multilayer film, for instance of the type disclosed by T.A. Lafford, M.R.J. Gibbs, and C. Shearwood in "Magnetic, magnetostrictive and structural properties of iron-cobalt/silver multilayers", Journal of Magnetism and Magnetic Materials 132 (1994) 89-94.

The beam may be driven to vibrate optically, i.e. by the effect of local thermal expansion on one side of the beam, or by electrostatic, piezoelectric or any other suitable excitation.

Advantageously the beam is driven at a frequency near or at the resonant frequency of the beam. Alternatively the driving frequency may be swept across a predetermined band of frequencies and the motion of the beam monitored to determine the resonant frequency of the beam.

In an alternative arrangement, the beam may be arranged to undergo auto-oscillation, whereby the beam resonates in response to illumination from a substantially non-varying light. Auto-oscillation may be achieved by illuminating the beam at an angle to the normal of the surface of the beam such that the intensity of the light impinging on the beam is a function of the position of the beam or the illuminated part thereof.

The motion of the beam may be sensed optically. Alternatively piezoelectric, piezoresistive, or capacitive detection may be used.

Optical detection has the advantage of great immunity to electrical noise.

The beam may be supported at either end thereof. Alternatively the beam may be provided as a cantilever.

As a further alternative, the measurable property of the beam may be the deflection of the beam. The beam may be arranged to act as a movable reflector within an interferometer. The interferometer may be illuminated with substantially monochromatic light, so that position may be determined by counting cyclic variations in intensity with changing position. Alternatively, the interferometer may be illuminated by polychromatic light so that the colour of light reflected from the interferometer is indicative of the position of the beam.

In a first preferred embodiment of the present invention, there is provided a magnetic field sensor comprising a beam and a stressing member of magnetostrictive material arranged such that the stressing member exerts a force which is a function of magnetic field on the beam thereby altering the resonant frequency of the beam in response to changes in the magnetic field.

The stressing member may be applied to a surface of the beam. For instance the stressing member may be a layer of nickel deposited on one side of the beam. The nickel may be deposited by sputtering.

As an alternative, the stressing member may be arranged to stress the body of the sensor and thereby exert a force on the beam.

In a second preferred embodiment of the present invention, there is provided a magnetic field sensor comprising a beam having a member of material which has an elastic modulus which is a function of magnetic field arranged such that the elastic modulus of the beam is a function of magnetic field thereby altering the resonant frequency of the beam in response to changes in the magnetic field.

The present invention will be further described, by way of example, with reference to the accompanying drawings, in which:
Figure 1 is a perspective view of a resonating beam magnetic field sensor constituting a first embodiment of the present invention;
Figure 2 shows the sensor of Figure 1 in a cross sectional view taken along the axis of the optical fibre; and
Figure 3 is a perspective view of a sensor constituting a second embodiment of the present invention.

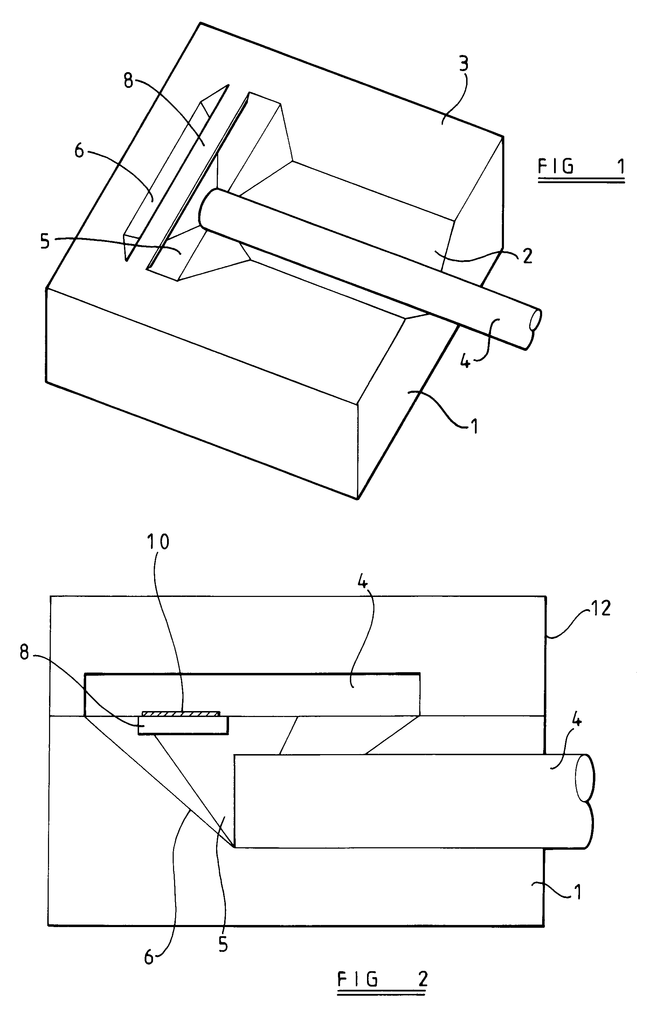

The magnetic field sensor shown in Figure 1 comprises a body 1 of monocrystalline silicon. A groove 2 is etched into a surface 3 of the block so as to define a passage for receiving and securing an optical fibre 4. A reflector 6 is etched into a side wall of a well 5 formed within the body 1. The reflector 6 is arranged transversely to the axis of the groove 2 and angled at 45 degrees thereto so as reflect light from the optical fibre 4 in a direction normal to the surface 3.

A bridge 8 formed above the reflector 6 is coated with a layer 10 of nickel. The bridge 8 is typically 800 micrometers long by 60 micrometers wide. The bridge 8 comprises silicon approximately 1-2µm thick with a 0.5µm thick layer of nickel deposited thereon, as shown in Figure 2. Alternatively, the layer 10 may comprise an iron-cobalt/silver multilayer, as mentioned hereinbefore, deposited on the silicon bridge.

Nickel exhibits magnetostriction. In the presence of a magnetic field, the length of the layer 10 of nickel tends to alter. The material of the bridge 8 acts to prevent the layer 10 changing in length. This causes the bridge to be stressed by an amount which is a function of the magnetic field at the layer 10.

The sensor is provided with a cover 12 which is bonded to the body 1 so as to define a region 14 enclosing the bridge 8. The region 14 is substantially evacuated so as to reduce damping effects on the bridge due to viscous drag.

The production of the body 1 with the groove 2, the well 5, the reflector and the bridge 8 as described above, is described in European Patent application 93300550.6 Serial No. 0 555 968 entitled "OPTICAL DEVICE AND A METHOD OF MANUFACTURE THEREOF" which is incorporated herein by reference.

In an alternative arrangement, the bridge 8 may be constructed of sputter deposited nickel approximately 0.5 micrometers thick.

The resonant frequency of the bridge 8 is a function of the stress experienced by the bridge. The bridge receives light from the optical fibre and reflects light back to the optical fibre. The intensity of the light received by the optical fibre 4 is modulated by the position of the bridge 8.

In use, the beam may be driven into oscillation by modulating the light incident on the lower surface of the bridge 8. Absorbtion of the light causes local heating and the resulting thermal expansion, and subsequent contraction when the light intensity is reduced, drives the bridge into vibration. The driving frequency is set to be substantially coincident with the resonant frequency of the bridge so as to increase the amplitude of vibration.

The amplitude of the vibration is determined by measuring the intensity of the light reflected back into the optical fibre 4 from the bridge 8 via the reflector 6. By measuring the vibrational amplitude of the bridge with changes in the driving frequency of the modulated light, the resonant frequency of the bridge can be determined and hence the strength of the magnetic field can be determined.

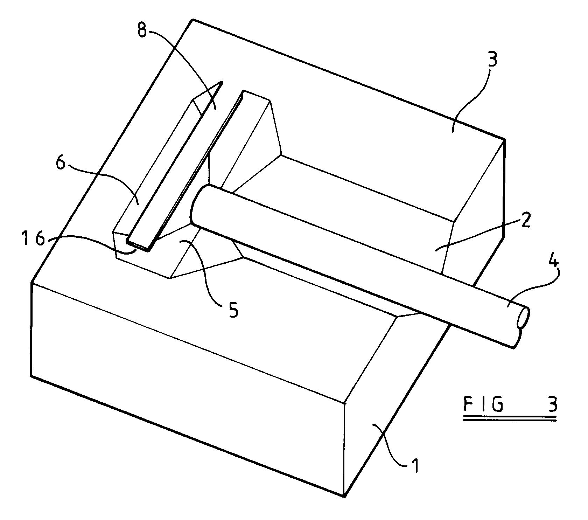

Figure 3 shows a second embodiment of a magnetic field sensor similar in structure to the first embodiment. Like reference numerals refer to like parts in Figures 1 and 3. The bridge 8 is formed as a cantilever having a free end 16. The bridge, as before, is driven optically and its motion is sensed optically.

The bridge may be provided by a silicon base coated with a layer of magnetostrictive material such as nickel, as in the first embodiment, such that the stress within the silicon and nickel change with magnetic field, thereby changing the resonant frequency of the bridge.

The sensor exhibits maximum sensitivity when the direction of the magnetic flux is aligned with the longitudinal axis of the bridge 8, whereas minimum sensitivity occurs when the magnetic field is perpendicular to the surface 3. The sensor's response is independent of the "polarity" of the magnetic field, that is it is insensitive to a complete reversal of the direction of the magnetic field.

As a further alternative, the bridge may be made of a material exhibiting the delta E effect such that the elastic modulus of the material of the bridge changes with magnetic field. The frequency of vibration of a cantilever varies, to a first approximation, with the square root of the elastic modulus of the material of the cantilever.

It is thus possible to provide a sensor having good sensitivity and immunity from electrical noise.

## Claims

1. A magnetic field sensor characterised by a beam (8) and changing means (10) responsive to a magnetic field for changing a measurable property of the beam (8).

2. A sensor as claimed in Claim 1, characterised in that the beam (8) is made of silicon.

3. A sensor as claimed in Claim 1 or 2, characterised in that the changing means (10) comprises a layer of magnetostrictive material on the beam (8).

4. A sensor as claimed in Claim 1, characterised in that the beam (8) is made of magnetostrictive material which constitutes the changing means.

5. A sensor as claimed in any one of the preceding claims, characterised in that the beam (8) is a bridge and the measurable property of the beam (8) is the resonant frequency of the beam (8).

6. A sensor as claimed in any one of Claims 1 to 4, characterised in that the beam (8) is a cantilever and the measurable property of the beam is the deflection of the beam (8).

7. A sensor as claimed in any one of the preceding claims, characterised by a light guiding arrangement (4, 6) for directing light onto and receiving light from the beam (8).

8. A sensor as claimed in Claim 7, characterised in that the light guiding arrangement (4, 6) is connected to a light source for illuminating the beam (8) and to a transducer responsive to the measurable property of the beam.

9. A sensor as claimed in Claims 7 or 8 when dependent on Claim 5, characterised in that the light source is arranged to produce light which is amplitude modulated substantially at the resonant frequency of the beam (8).

10. A magnetic field sensor as claimed in claim 1, in which the changing means is a stressing member (10) of magnetostrictive material arranged such that the stressing member (10) exerts a force which is a function of magnetic field on the beam (8) thereby altering the resonant frequency of the beam in response to changes in the magnetic field, and in which the stressing member (10) is applied to a surface of the beam (8) or the stressing member is arranged to stress a body of the sensor so as to exert a force on the beam.

11. A magnetic field sensor as claimed in claim 1, in which the beam has a member of material which has an elastic modulus which is a function of magnetic field arranged such that the elastic modulus of the beam is a function of magnetic field thereby altering the resonant frequency of the beam in response to changes in the magnetic field.
